# EUROPEAN PATENT APPLICATION

(11) **EP 1 553 669 A1**
(43) Date of publication of application: **13.07.2005**
(21) Application number: 03808894.4
(22) Date of filing: 29.09.2003
(51) Int. Cl.: H01S 5/323

(54) **GROUP III NITRIDE SEMICONDUCTOR LIGHT-EMITTING DEVICE AND METHOD FOR MANUFACTURING SAME**

(30) Priority: 15.10.2002 JP 2002300425
(71) Applicant: Pioneer Corporation, Tokyo 153-8654 (JP)
(72) Inventor: WATANABE, Atsushi, Corporate Research and Dev., Tsurugashima-shi, Saitama 350-2288 (JP); TAKAHASHI, Hirokazu, Corporate Research and Dev., Tsurugashima-shi, Saitama 350-2288 (JP); KIMURA, Yoshinori, Corporate Research and Dev., Tsurugashima-shi, Saitama 350-2288 (JP); MIYACHI, Mamoru, Corporate Research and Dev., Tsurugashima-shi, Saitama 350-2288 (JP)
(74) Representative: Goddar, Heinz J., Dr.
(86) International application number: PCT/JP2003/012406
(87) International publication number: WO 2004/036708

(57) **Abstract**

A Group III nitride semiconductor light-emitting element includes a crack-preventing layer 15 of n-type GaN provided between a n-type contact layer 4Ȧ and a n-type clad layer 5A, wherein the crack-preventing layer 15 has a dopant concentration lower than that of the n-type contact layer 4A.

## Description

### FIELD OF THE INVENTION

The present invention relates to a Group III nitride semiconductor light-emitting element, and a method of manufacturing the same.

### BACKGROUND ART

In recent years, a light-emitting diode (hereinafter referred to as "LED") and a laser diode (hereinafter referred to as "LD"), both formed of a Group III nitride semiconductor, are known.

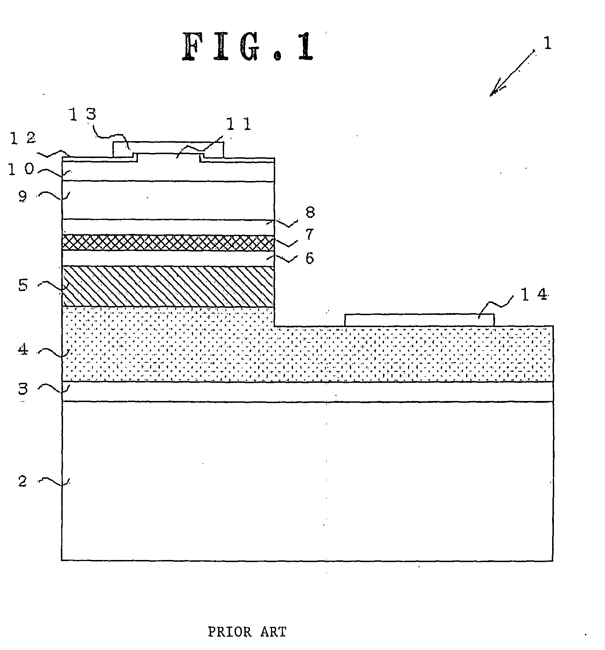

In an LD element 1 shown in Fig. 1, which is made by using Group III nitride semiconductor materials, there are formed, on a substrate 2 of sapphire, a buffer layer 3 of AlN, an n-type contact layer 4 of n-type GaN, an n-type clad layer 5 made of n-type AlGaN, an n-type guide layer 6 of n-type GaN, an active layer 7 having a main component of InGaN, a p-type guide layer 8 of p-type GaN, a p-type clad layer 9 of p-type AlGaN, and a p-type contact layer 10 of p-type GaN, one upon another in the mentioned order. The p-type contact layer 10 is formed with a convex ridge 11 protruding in the direction of the thickness thereof. An insulating layer is formed except on a flat top of the ridge 11, and a p-type electrode 13 is provided in a manner of covering the ridge 11. It should be noted that an n-type electrode 14 is formed on the n-type contact layer 4.

When a forward bias voltage is applied between the p-type electrode 13 and the n-type electrode 14, holes and electrons are respectively injected from the p-type electrode 13 and the n-type electrode 14 into the LD element 1 as carriers, and recombined with each other in the active layer 7 to emit light.

The LD element 1 constructed as above is configured such that the active layer is sandwiched from opposite sides thereof by the guide layers, and further the active layer and the guide layers are sandwiched from outside by the clad layers, whereby the carriers are confined within the active layer by the guide layers and the light is confined within the guide layers and the active layer by the clad layers. This structure is known as an SCH structure (Separate Confinement Heterostructure).

The Group III nitride semiconductor laser element having the SCH structure mentioned above can enhance the light confinement factor of the element by increasing the thickness of the clad layers or the mole fraction of AlN in the clad layers.

However, it is known that when the thickness of the n-type clad layer 5 of AlGaN is increased, or the mole fraction of AIN in the layer is increased, a tensile stress is generated in the n-type clad layer 5, since a lattice constant of AlGaN is smaller than a lattice constant of GaN, which causes cracks liable to be formed (see, for example, Japanese Patent Application Kokai No.H11-74621). The thickness of the n-type clad layer 5 at which cracking starts to occur is called "critical layer thickness of crack generation" or simply "critical layer thickness". The cracks generated in the n-type clad layer 5 degrade light-emitting properties of the LD element.

To overcome the problem, as means for preventing generation of cracks in the n-type clad layer, it has been proposed to provide a crack-preventing layer(not shown) between the n-type contact layer and the n-type clad layer for alleviating the tensile stress generated in the n-type clad layer. The crack-preventing layer is formed of InGaN having a thickness of 100 angstrom to 0.5 µm (see, for example, Japanese Patent Application Kokai No. H9-148247).

In the conventional light-emitting element in which the InGaN layer is provided between the GaN layer and the AlGaN layer so as to reduce the occurrence of cracking, it is required to raise or lower the temperature of the substrate before and after forming the crack-preventing layer, since the growth temperature (approximately 700°C to 800°C) of an InGaN crystal is lower than the growth temperatures (approximately 1000°C to 1100°C) of GaN and AlGaN crystals. Further, the crystal growth rate of InGaN is lower than that of GaN, so that it takes a long time to manufacture the light-emitting element.

Further, InGaN requires a larger amount of nitrogen source material which is used in crystal growth reaction such as ammonia or the like, than GaN does, which results in increased manufacturing costs for the light-emitting element.

Further, InGaN has a larger refractive index than those of GaN and AlGaN, and therefore light which is not completely confined by the clad layer is more likely to leak when the InGaN layer is used as a layer underlying the n-type clad layer. Moreover, the crack-preventing layer acts as a light-absorbing layer when the In composition of the crack-preventing layer is equal to or larger than that of the light-emitting layer, causing a waveguide loss. This is an adverse factor of a rise in a threshold current value.

### SUMMARY OF THE INVENTION

Problems to be solved by the present invention include, for example, the above-mentioned problem.

According to the present invention, there is provided a Group III nitride semiconductor light-emitting element including an n-type contact layer of n-type GaN, an n-type clad layer of n-type AlₓGa_{1-x-y}In_{y}N (0<x<1, 0≤y<1, 0<x+y<1), an active layer, a p-type clad layer, and a p-type contact layer, which comprises a crack-preventing layer of n-type GaN provided between the n-type contact layer and the n-type clad layer, wherein the crack-preventing layer has a dopant concentration lower than that of the n-type contact layer.

According to another aspect of the present invention, there is provided a method of manufacturing a semiconductor light-emitting element having a multilayered structure constituted by sequentially stacking layers of Group III nitride semiconductors one upon another on a substrate, the method comprises the steps of forming an n-type contact layer of n-type GaN, and forming a crack-preventing layer of n-type GaN, the crack-preventing layer having a dopant concentration lower than that of the n-type contact layer.

### BRIEF DESCRIPTION OF THE DRAWINGS

Fig. 1 is a cross-sectional view of a conventional LD element.
Fig. 2 is a cross-sectional view of an LD element according to the present invention.
Fig. 3 is a photograph showing a surface of an n-type clad layer provided on a GaN layer of which dopant concentration is 4 x 10¹⁸ cm⁻³.
Fig. 4 is a photograph showing a surface of an n-type clad layer provided on a GaN layer of which dopant concentration is 2 x 10¹⁸ cm⁻³.

### DETAILED DESCRIPTION OF THE INVENTION

The embodiment of the present invention will now be described in detail with reference to the drawings. It should be noted that in the figures, component parts and elements similar or equivalent to each other are designated by identical reference numerals.

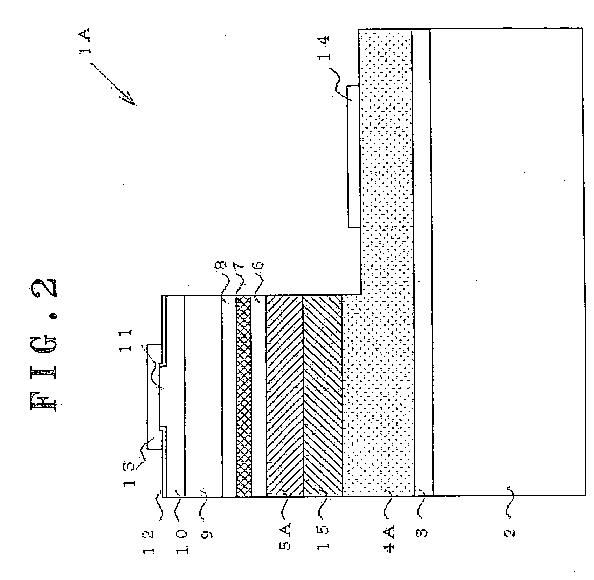

Referring first to Fig. 2, an LD element 1A according to the embodiment includes a buffer layer 3 of A1N provided on a sapphire substrate 2. The buffer layer 3 has a thickness of approximately 50 nm.

There is provided an n-type contact layer 4A of n-type GaN on the buffer layer 3. The n-type contact layer 4A contains Si as a dopant. The atomic concentration of Si is 1 x 10¹⁹ cm⁻³. It is preferable that the dopant concentration be within a range of 4 x 10¹⁸ cm⁻³ to 2 x 10¹⁹ cm⁻³. This is because the dopant concentration within the range contributes to reduction of series resistance of the whole LD element.

An n-type electrode 14 is formed on the n-type contact layer 4A, and there is formed a crack-preventing layer 15 of n-type GaN at a location away from the n-type electrode 14. The crack-preventing layer 15 contains an Si dopant having a concentration of 1 x 10¹⁷ cm⁻³, and has a thickness of 2 µm. It is preferred that the concentration of the Si dopant contained in the crack-preventing layer 15 is lower than that of the Si dopant contained in the n-type contact layer 4A, preferably lower than 4 x 10¹⁸ cm⁻³. It is more preferable that the concentration of the Si dopant be within a range of 5 x 10¹⁶ cm⁻³ to 5 x 10¹⁷ cm⁻³.

It may be presumed that due to the dopant concentration of the crack-preventing layer 15 lower than that of the n-type contact layer 4A, the resistance of the crack-preventing layer 15 becomes high, causing an increase in the driving voltage of the LD element. However, mobility of carriers is increased as the dopant concentration is reduced, whereby an increase in the resistivity of the crack-preventing layer 15 is suppressed. Further, the length of a current path in the crack-preventing layer 15 is equal to the thickness of the crack-preventing layer 15, since a current flows in the direction of the thickness of the crack-preventing layer 15a. More specifically, the thickness of the crack-preventing layer 15 is several µm, whereas the length of a current path through the whole LD element 1A is on the order of 100 µm, so that the ratio of the resistance value of the crack-preventing layer 15 to the resistance value of the whole LD element 1A is small. Therefore, even if the crack-preventing layer 15 of n-type GaN having a low dopant concentration is provided in the LD element, the adverse influence on the resistance of the whole element is small.

An n-type clad layer 5A of n-type Al_{0.08}Ga_{0.92}N is formed on the crack-preventing layer 15. The n-type clad layer 5A has a thickness of 1.2 µm, and an Si dopant concentration of 2 x 10¹⁸ cm⁻³.

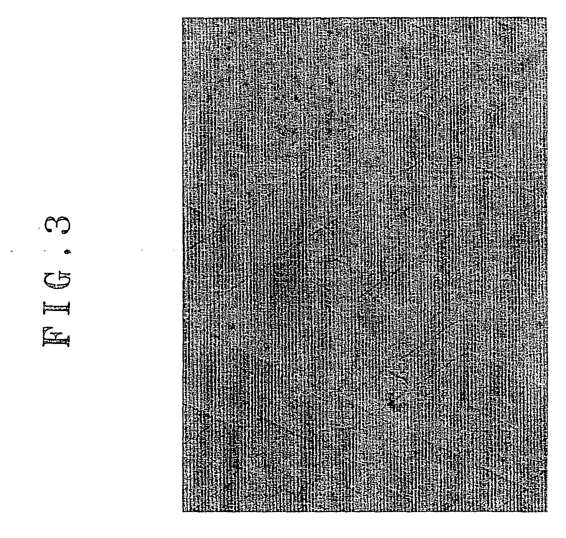

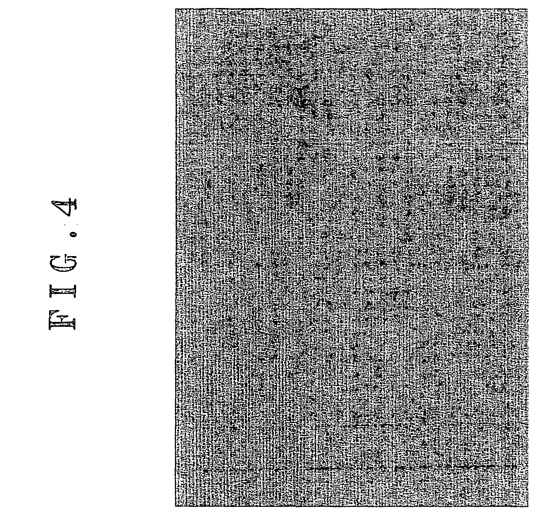

The provision of the crack-preventing layer 15 of n-type GaN having a low Si dopant concentration immediately under the n-type clad layer 5A has increased the critical layer thickness of the n-type clad layer 5A. This is clearly shown in Fig. 3 and Fig. 4 which illustrate occurrence of cracking in respective cases where n-type clad layers made of n-type Al_{0.08}Ga_{0.92}N and at the same time having a thickness of 0.5 µm are formed on n-type GaN layers having different Si dopant concentrations. More specifically, an n-type GaN layer having a lower Si dopant concentration (shown in Fig. 4) is lower in density of occurrence of cracks. It is presumed that the reduced dopant concentration makes the GaN crystal less prone to a hardening phenomenon caused by doping, and this makes it possible to deform the n-type GaN layer, thereby decreasing a tensile stress in the n-type clad layer on the GaN layer.

The critical layer thickness of the n-type clad layer 5A depends not only on the dopant concentration of the crack-preventing layer 15 but also on (1) the mole fraction of AlN in the n-type clad layer 5A, and (2) the dopant concentration of the n-type clad layer 5A. When the respective values of the two parameters are increased, the critical layer thickness is reduced, making cracking more likely to be caused. However, the provision of the crack-preventing layer 15 makes it possible to increase the respective values of the parameters. By increasing the (1) parameter of the mole fraction of AlN, it was possible to effectively confine the light generated in the LD element 1A. Further, by increasing the (2) parameter of the dopant concentration, resistivity of the n-type clad layer was reduced to decrease series resistance of the element, whereby the driving voltage of the element was lowered.

It should be noted that the n-type clad layer 5A can be formed by AlₓGa_{1-x-y}In_{y}N (0<x<1, 0≤y<1, 0<x+y<1).

On the n-type clad layer 5A, there are formed an n-type guide layer 6 of n-type GaN having a thickness of 0.05 µm, and an active layer 7 one upon the other in the order mentioned. The active layer 7 is a multiple-quantum-well (hereinafter referred to as "MQW") active layer formed by depositing barrier layers (not shown) of InGaN containing Si dopant, and well layers (not shown) containing no Si dopant and formed of InGaN having a larger In concentration than the barrier layers, alternately, from the side of the n-type guide layer 6, until a predetermined number of wells are formed, and finally depositing a barrier layer on top of the layers.

On the active layer 7, similar to the LD element 1 illustrated in Fig. 1, there are formed a p-type guide layer 8 of p-type GaN, a p-type clad layer 9 of p-type AlGaN, a p-type contact layer 10 of p-type GaN, and a p-type electrode 13, one upon another, in the order mentioned. It should be noted that an electron barrier layer (not shown) of p-type AlGaN may be inserted between the active layer 7 and the p-type guide layer 8.

Then, a description will be made for a method of manufacturing the LD element described above.

A sapphire wafer as a substrate is placed in a reactor of an MOCVD (Metal-Organic Chemical Vapor Deposition) system, and held in a hydrogen stream having a pressure of 300 Torr at a temperature of 1050°C, for ten minutes, to have surface thereof cleaned. Then, the sapphire substrate is cooled to 400°C, and ammonia (NH₃), which is a nitrogen source material, and trimethylaluminum (TMA), which is an aluminum source material, are introduced into the reactor, whereby a buffer layer is deposited.

After the buffer layer has been formed, in a condition in which the supply of TMA has been stopped with NH₃ alone continuing to be supplied, the temperature of the substrate is raised again to 1050°C, and then trimethylgallium (TMG) is introduced into the reactor to carry out an n-type contact-layer forming step for growing an n-type contact layer of n-type GaN. In the n-type contact-layer forming step, methylsilane (Me-SiH₃) is added to a growth ambient gas as a source material of Si. The amount of Me-SiH₃ to be added is adjusted such that the atomic concentration of Si in the resulting layer becomes equal to 1 x 10¹⁹ cm⁻³.

After the n-type contact layer is grown to a thickness of 10 µm, the flow rate of Me-SiH₃ is reduced to carry out a crack-preventing-layer forming step of forming a crack-preventing layer which has an atomic concentration of Si of 1 x 10¹⁷ cm⁻³. In the crack-preventing-layer forming step, it is only required to reduce the flow rate of Me-SiH₃, which is a dopant material, out of the materials used in the n-type contact-layer forming step, and it is unnecessary to supply any other material to the reactor, or raise or lower the temperature in the reactor. In other words, the same materials are used for forming the n-type contact layer and the crack-preventing layer, which makes it possible to reduce material costs and time required for manufacturing the LD element.

TMA is introduced into the reactor to form an n-type clad layer of n-type Al_{0.08}Ga_{0.92}N. The amount of Me-SiH₃ permitted to flow into the reactor is adjusted such that the atomic concentration of Si in the n-type clad layer becomes equal to 2 x 10¹⁸ cm⁻³. Since the crystal growth temperature of AlGaN crystal is approximately equal to that of GaN, there is no need to raise or lower the temperature in the reactor.

Then, the supply of TMA is stopped, and an n-type guide layer of n-type GaN is grown to a thickness of 0.05 µm. When the growth of the n-type GaN guide layer has been completed, the supply of TMG and Me-SiH₃ is stopped, and the substrate temperature is lowered to 770°C.

After the substrate temperature has been lowered to 770°C, the carrier gas, i.e. the source material-transporting gas, is switched from a hydrogen gas to a nitrogen gas, and TMG, trimethylindium (TMI), and Me-SiH₃, are introduced to cause deposition of a barrier layer. Then, the supply of Me-SiH₃ is stopped and at the same time the flow rate of TMI is increased, whereby a well layer having a larger In composition than the barrier layer is deposited. The growth of a barrier layer and that of a well layer are repeatedly performed in accordance with a design repetition number set for the MQW. A barrier layer is grown on a final well layer to complete forming of an MQW active layer.

The supply of TMI and Me-SiH₃ is stopped. Then, TMA and ethylcyclopentadienylmagnesium (EtCp2Mg) as an Mg source material are introduced in stead of the TMI and Me-SiH₃, to thereby grow an electron barrier layer of Mg-doped AlGaN. When the thickness of the electron barrier layer has reached 200 angstrom, the supply of TMG, TMA, and EtCp2Mg is stopped, and further the carrier gas is changed from the nitrogen gas to the hydrogen gas and the increase of the temperature is started.

After the substrate temperature has reached 1050°C, TMG and EtCp2Mg are introduced to grow a p-type guide layer of Mg-doped GaN. When the thickness of the p-type guide layer has reached 0.05 µm, TMA is introduced to deposit a p-type clad layer of Mg-doped Al_{0.08}Ga_{0.92}N.

After the p-type clad layer has been grown to a thickness of 0.5 µm, the supply of TMA is stopped to grow a p-type contact layer of Mg-doped GaN. When the thickness of the p-type contact layer has become equal to 0.1 µm, the supply of TMG and EtCp2Mg is stopped and the lowering of the temperature is started. When the substrate temperature is lowered to 400°C or less, the supply of NH₃ is stopped. After the substrate temperature has become equal to room temperature, a wafer having the layers of an LD structure deposited thereon is taken out from the reactor.

Subsequently, after carrying out a conventional photolithographic process and dry etching to form a ridge on the p-type contact layer, an insulating layer is formed except on a flat top of the ridge, and further, a p-type electrode is formed. Similarly, an n-type electrode is formed after causing the n-type contact layer to be exposed by partial etching. The wafer is divided into elements, whereby LD elements are obtained.

Although sapphire is used as a substrate material, this is not limitative, but it is possible to use an SiC substrate, a GaN bulk substrate, an Si substrate, and a substrate formed by growing GaN in advance on a substrate, for example, of sapphire.

The characteristics of the LD element made by carrying out the above-described steps were measured. The measurement was carried out using an LD element having a ridge width of 2 µm, and a cavity length of 0.6 mm. It should be noted that as a conventional LD element, the same LD element 1 as shown in Fig. 1 was used. The conventional LD element had an n-type contact layer 4 having an Si dopant concentration of 2 x 10¹⁸ cm⁻³, and an n-type clad layer 5 having a thickness of 0.8 µm.

In a light-emitting element according to the embodiment of the present invention, laser oscillation occurred at a wavelength of 405 nm, with a threshold current value of 40 mA. Further, the driving voltage of the light-emitting element was 5.4 V at an output of 5 mW. On the other hand, in the conventional light-emitting element, laser oscillation occurred at a wavelength of 406 nm, with a threshold current value of 45 mA. At an output of 5 mW, the driving voltage of the conventional light-emitting element was 6.2 V. Thus, it was possible to reduce the series resistance of the LD element without generating cracks in the n-type clad layer by providing the n-type contact layer having a higher dopant concentration and the crack-preventing layer having a dopant concentration lower than that of the n-type contact layer within the LD element.

An FFP (Far Field Pattern) of a laser beam emitted from each of the above-described LD elements was measured. As to the laser beam emitted from the conventional LD element, side peaks due to leakage of the beam were observed at both sides of a main peak. In contrast, the laser beam emitted from the LD element according to the present invention exhibited a Gaussian distribution. It is presumed that critical conditions of generating a cracking were relaxed by providing the crack-preventing layer, whereby it became possible to form an n-type clad layer having a larger thickness than that of the n-type clad layer of the conventional element, which contributed to improvement of the light confinement effect of the element, thereby improving the FFP.

Although in the above embodiment, Si is used as the n-type dopant, this is not limitative, but Ge can be used as well.

Further, although the description has been given of the LD elements only, the present invention is not limited to the LD elements. The present invention can be also applied to LEDs (Light-Emitting Diodes). Particularly, in a case of a short-wavelength LED for emitting light having a wavelength of 360 nm or shorter, the GaN layer serves as a light-absorbing layer, so that an AlGaN clad layer having a high Al composition, or a Bragg reflector structure is required to be provided under the active layer. Therefore, it is very effective to insert a crack-preventing layer having a low dopant concentration between the clad layer and the n-type contact layer.

According to a Group III nitride semiconductor light-emitting element including an n-type contact layer of n-type GaN, an n-type clad layer of n-type AlₓGa_{1-x-y}In_{y}N (0<x<1, 0≤y<1, 0<x+y<1), an active layer, a p-type clad layer, and a p-type contact layer, the light-emitting element comprising a crack-preventing layer of n-type GaN provided between the n-type contact layer and the n-type clad layer, wherein the crack-preventing layer has a dopant concentration lower than that of the n-type contact layer, it is possible to increase the thickness of the n-type clad layer or the mole fraction of AlN in the n-type clad layer without causing cracking due to provision of the crack-preventing layer having a low dopant concentration. Thus, the light-emitting efficiency of the element can be improved. Moreover, it is possible to decrease series resistance of the element since the dopant concentration of the n-type contact layer can be increased.

According to a method of manufacturing a semiconductor light-emitting element having a multilayered structure obtained by sequentially forming layers of Group III nitride semiconductors one upon another on a substrate, the method comprising the steps of forming an n-type contact layer of n-type GaN, and forming a crack-preventing layer of n-type GaN, the crack-preventing layer having a dopant concentration lower than that of the n-type contact layer, it is possible to form both the n-type contact layer and the crack-preventing layer from the same materials, and therefore, it is possible to reduce material costs and time required for manufacturing the semiconductor light-emitting element.

## Claims

1. A Group III nitride semiconductor light-emitting element including an n-type contact layer of n-type GaN, an n-type clad layer of n-type AlₓGa_{1-x-y}In_{y}N (0<x<1, 0≤y<1, 0<x+y<1), an active layer, a p-type clad layer, and a p-type contact layer, comprising:
a crack-preventing layer of n-type GaN provided between the n-type contact layer and the n-type clad layer,
wherein the crack-preventing layer has a dopant concentration lower than that of the n-type contact layer.

2. The light-emitting element according to claim 1, wherein the crack-preventing layer has a dopant concentration lower than 4 x 10¹⁸ cm⁻³.

3. The light-emitting element according to claim 2, wherein the crack-preventing layer has a dopant concentration within a range of 5 x 10¹⁶ cm⁻³ to 5 x 10¹⁷ cm⁻³.

4. The light-emitting element according to claim 1, wherein the n-type contact layer has a dopant concentration within a range of 4 x 10¹⁸ cm⁻³ to 2 x 10¹⁹ cm⁻³.

5. The light-emitting element according to claim 1, wherein a dopant of the crack-preventing layer is either one of Si and Ge.

6. The light-emitting element according to claim 1, wherein a dopant of the n-type contact layer is either one of Si and Ge.

7. A method of manufacturing a semiconductor light-emitting element having a multilayered structure constituted by sequentially stacking layers of Group III nitride semiconductors one upon another on a substrate, the method comprising:
an n-type contact-layer forming step of forming an n-type contact layer of n-type GaN, and
a crack-preventing layer forming step of forming a crack-preventing layer of n-type GaN, the crack-preventing layer having a dopant concentration lower than that of the n-type contact layer.

8. The method according to claim 7, wherein the crack-preventing layer forming step includes a step of reducing an amount of supply of a dopant material used in the n-type contact-layer forming step.

## Amended claims

### Amended claims under Art. 19.1 PCT

**1.** (Amended) A Group III nitride semiconductor light-emitting element including an n-type contact layer of n-type GaN, an n-type clad layer of n-type AlₓGa₁₋ₓN (0<x<1), an active layer, a p-type clad layer, and a p-type contact layer, comprising:
a crack-preventing layer of n-type GaN provided between the n-type contact layer and the n-type clad layer,
wherein the crack-preventing layer has a dopant concentration lower than that of the n-type contact layer.

**2.** The light-emitting element according to claim 1, wherein the crack-preventing layer has a dopant concentration lower than 4 x 10¹⁸ cm⁻³.

**3.** The light-emitting element according to claim 2, wherein the crack-preventing layer has a dopant concentration within a range of 5 x 10¹⁶ cm⁻³ to 5 x 10¹⁷ cm⁻³.

**4.** The light-emitting element according to claim 1, wherein the n-type contact layer has a dopant concentration within a range of 4 x 10¹⁸ cm⁻³ to 2 x 10¹⁹ cm⁻³.

**5.** The light-emitting element according to claim 1, wherein a dopant of the crack-preventing layer is either one of Si and Ge.

**6.** The light-emitting element according to claim 1, wherein a dopant of the n-type contact layer is either one of Si and Ge.

**7.** (Amended) A method of manufacturing a semiconductor light-emitting element having a multilayered structure constituted by sequentially stacking layers of Group III nitride semiconductors one upon another on a substrate, the method comprising:
an n-type contact-layer forming step of forming an n-type contact layer of n-type GaN,
a crack-preventing layer forming step of forming a crack-preventing layer of n-type GaN, the crack-preventing layer having a dopant concentration lower than that of the n-type contact layer 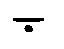 , and
a clad-layer forming step of forming an n-type clad layer of n-type AlₓGa₁₋ₓN (0<x<1) on the crack-preventing layer.

**8.** The method according to claim 7, wherein the crack-preventing layer forming step includes a step of reducing an amount of supply of a dopant material used in the n-type contact-layer forming step.
